# EUROPEAN PATENT APPLICATION

(11) **EP 4 513 572 A1**
(43) Date of publication of application: **26.02.2025**
(21) Application number: 23854181.7
(22) Date of filing: 20.07.2023
(51) Int. Cl.: H01L 29/739, H01L 21/331, H01L 29/417, H01L 29/423, H01L 21/265

(54) **IGBT DEVICE HAVING DEEP BUFFER LAYER AND HIGH-DENSITY TRENCHES, AND PREPARATION METHOD FOR IGBT DEVICE**

(30) Priority: 15.08.2022 CN 202210973107
(71) Applicant: Chongqing Alpha and Omega Semiconductor Limited, Chongqing 400700 (CN)
(72) Inventor: QIN, Xiaofeng, Chongqing 400700 (CN); SHI, Liang, Chongqing 400700 (CN); HU, Wei, Chongqing 400700 (CN)
(74) Representative: Zaboliene, Reda
(86) International application number: PCT/CN2023/108471
(87) International publication number: WO 2024/037276

(57) **Abstract**

An IGBT device and a preparation method thereof are provided. The preparation method comprises steps A-E. The step A comprises preparing epitaxial layers. The step B comprises preparing a front-face terminal structure. The high-density trenches comprise cellular active trenches, cellular pseudo trenches, and scribe line trenches. The step C comprises preparing a front-face high-density-trench MOSFET structure having high-density trenches. The step D comprises preparing a circuit link layer and a passivation layer. The step E comprises preparing a back face of the IGBT device. The preparation method solves a warpage problem when producing IGBT devices on a large-size wafer. At the same time, a depth of a buffer layer of the IGBT device and a concentration of a first element in the buffer layer are easy to adjust, which fully meets requirements for trench density, trench type, and buffer layer, and improves a yield rate of the IGBT devices.

## Description

### TECHNICAL FIELD

The present disclosure relates to a field of semiconductor device manufacturing, and in particular to an insulated gate bipolar transistor (IGBT) device having a deep buffer layer and high-density trenches and a preparation method thereof.

### BACKGROUND

A backside electric field cutoff layer of conventional IGBT devices is generally obtained by performing high-energy ion implantation and performing thermal annealing or laser annealing. For instance, when an implanted element is phosphorus or arsenic and an implantation depth thereof is 2-3um, after laser annealing, the backside electric field cutoff layer having a depth of 3-6um and a concentration of 1e16-1e17/ is obtained. When using light ions such as protons and helium for the ion implantation and an implantation depth thereof is 2-40um, after thermal annealing, the backside electric field cutoff layer having a depth of 3-40um and a concentration of e16-1e17/ is obtained. However, cost of a machine to perform such high-energy ion implantation is high, and requirements for the thermal annealing are high. It is necessary to increase an activation rate as much as possible while ensuring a low activation temperature.

A trench depth of the conventional IGBT devices is 4-7um. As a trench density continues to increase, a wafer for preparing the conventional IGBT devices is prone to very large warpage during a production process, and after the wafer is thinned to perform high-energy ion implantation and annealing on a backside of the wafer, stress distribution of the wafer is uneven, causing the wafer to break, and making it impossible to prepare the conventional IGBT devices on large-size wafers.

### SUMMARY

In order to solve defects in the prior art, the present disclosure provides a preparation method of an insulated gate bipolar transistor (IGBT) device having a deep buffer layer and high-density trenches.

The preparation method comprises steps A-E. The step A comprises preparing epitaxial layers. The step B comprises preparing a front-face terminal structure. The high-density trenches comprise cellular active trenches, cellular pseudo trenches, and scribe line trenches. The step C comprises preparing a front-face high-density-trench metal oxide semiconductor field effect transistor (MOSFET) structure having high-density trenches. The step D comprises preparing a circuit link layer and a passivation layer. The step E comprises preparing a back face of the IGBT device.

Furthermore, the step A comprises steps S1-S2. The step S1 comprises growing a first epitaxial layer on an upper surface of a semiconductor substrate by vapor deposition and doping the first epitaxial layer with a first element.

The step S2 comprises growing a second epitaxial layer on the first epitaxial layer by the vapor deposition and doping the second epitaxial layer with a second element. The first element is a trivalent element or a pentavalent element, the second element is the trivalent element or the pentavalent element.

The present disclosure further provides an IGBT device having a deep buffer layer and high-density trenches. The IGBT device is prepared by the preparation method mentioned above.

In summary, compared with the prior art, in the preparation method of the present disclosure, the high-density trenches are defined in both of the main region and the scribe line implantation regions, which reduces a warpage degree of a wafer in which the IGBT device is prepared, thus enabling a production of IGBT devices having the high-density trenches in the wafer having a large sizes.

The front-face high-density-trench MOSFET structure of the IGBT device of the present disclosure has the high-density trenches. Without increasing process costs, using different front-side processing technologies, such as implanting enhancement and carrier storage and other technologies, a capacitance composition ratio of the IGBT device of the present disclosure is easily adjusted to meet the needs of different application scenarios.

High-energy ion implantation or annealing is not necessary to be performed on a buffer layer of the IGBT device of the present disclosure, which reduces a risk of breakage of the wafer caused by performing the high-energy ion implantation or the annealing.

A depth and element concentration of the buffer layer of the IGBT device are capable of being easily adjusted. Therefore, an efficiency of ion implantation and a transport coefficient of the buffer layer of the IGBT are adjustable. Thus, IGBT devices having different turn-off characteristics are capable of being prepared to meet requirements of different application scenarios.

Scribe line implantation regions of IGBT device of the present disclosure comprise the same trench structures as the main region, which reduces a warpage degree of a wafer and enables a preparation of the IGBT devices having the high-density trenches on the wafer having a larger size.

An ion implantation depth and an element concentration on a backside of the buffer layer of the IGBT device are easily adjusted in the present disclosure. Therefore, an ion implantation efficiency and transport coefficient on a backside of the IGBT device are adjustable, which realizes preparations of the IGBT devices with different turn-off characteristics and meets the requirements of different application scenarios.

### BRIEF DESCRIPTION OF DRAWINGS

FIG. 1 is a top-plan schematic diagram of an IGBT device of the present disclosure.
FIG. 2 is a schematic diagram of the IGBT device after a step S1 in a step A of a preparation method of the IGBT device is performed.
FIG. 3 is a schematic diagram of the IGBT device after a step S2 in the step A of the preparation method of the IGBT device is performed.
FIG. 4 is a schematic diagram of the IGBT device after a step S3 in a step B of the preparation method of the IGBT device is performed.
FIG. 5 is a schematic diagram of the IGBT device after a step S4 in the step B of the preparation method of the IGBT device is performed.
FIG. 6 is a schematic diagram of the IGBT device after a step S5 in the step B of the preparation method of the IGBT device is performed.
FIG. 7 is a schematic diagram of the IGBT device after a step S6 in the step B of the preparation method of the IGBT device is performed.
FIG. 8 is a schematic diagram of the IGBT device after a step S7 in a step C of the preparation method of the IGBT device is performed.
FIG. 9 is a schematic diagram of the IGBT device after a step S8 in the step C of the preparation method of the IGBT device is performed.
FIG. 10 is a schematic diagram of the IGBT device after a step S9 in the step C of the preparation method of the IGBT device is performed.
FIG. 11 is a schematic diagram of the IGBT device after a step S10 in the step C of the preparation method of the IGBT device is performed.
FIG. 12 is a schematic diagram of the IGBT device after a step S11 in the step C of the preparation method of the IGBT device is performed.
FIG. 13 is a schematic diagram of the IGBT device after a step S12 in the step C of the preparation method of the IGBT device is performed.
FIG. 14 is a schematic diagram of the IGBT device after a step S13 in the step C of the preparation method of the IGBT device is performed.
FIG. 15 is a schematic diagram of the IGBT device after a step S14 in the step C of the preparation method of the IGBT device is performed.
FIG. 16 is a schematic diagram of the IGBT device after a step S15 in the step C of the preparation method of the IGBT device is performed.
FIG. 17 is a schematic diagram of the IGBT device after a step S16 in the step C of the preparation method of the IGBT device is performed.
FIG. 18 is a schematic diagram of the IGBT device after a step S17 in the step C of the preparation method of the IGBT device is performed.
FIG. 19 is a schematic diagram of the IGBT device after a step S18 in the step C of the preparation method of the IGBT device is performed.
FIG. 20 is a schematic diagram of the IGBT device after a step S19 in a step D of the preparation method of the IGBT device is performed.
FIG. 21 is a schematic diagram of the IGBT device after a step S20 in the step D of the preparation method of the IGBT device is performed.
FIG. 22 is a schematic diagram of the IGBT device after a step S21in the step D of the preparation method of the IGBT device is performed.
FIG. 23 is a schematic diagram of the IGBT device after a step S22 in the step D of the preparation method of the IGBT device is performed.
FIG. 24 is a schematic diagram of the IGBT device after a step S23 in the step D of the preparation method of the IGBT device is performed.
FIG. 25 is a schematic diagram of the IGBT device after a step S24 in a step E of the preparation method of the IGBT device is performed.
FIG. 26 is a schematic diagram of the IGBT device after a step S25 in the step E of the preparation method of the IGBT device is performed.
FIG. 27 is a schematic diagram of the IGBT device after a step S26 in the step E of the preparation method of the IGBT device is performed.
FIG. 28 is a schematic diagram of the IGBT device after a step S27 in the step E of the preparation method of the IGBT device is performed.
FIG. 29 is a cross-sectional schematic diagram of the IGBT device

### DETAILED DESCRIPTION

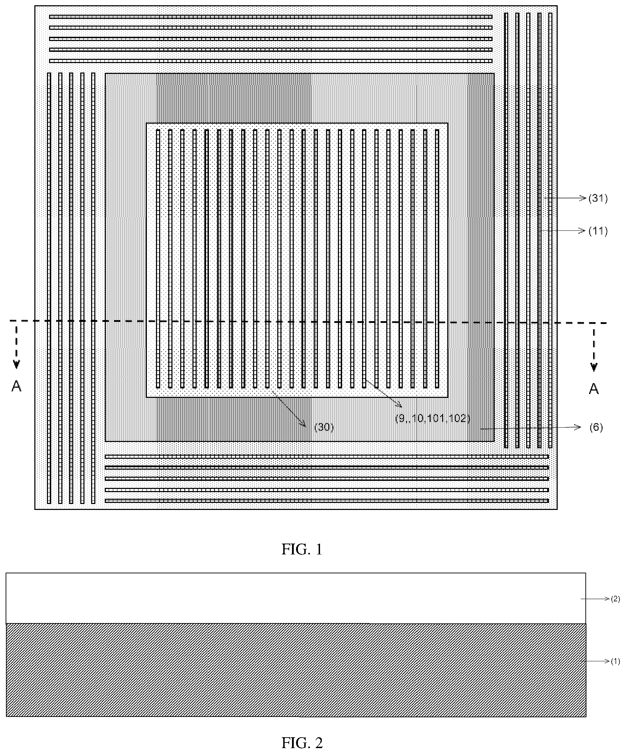

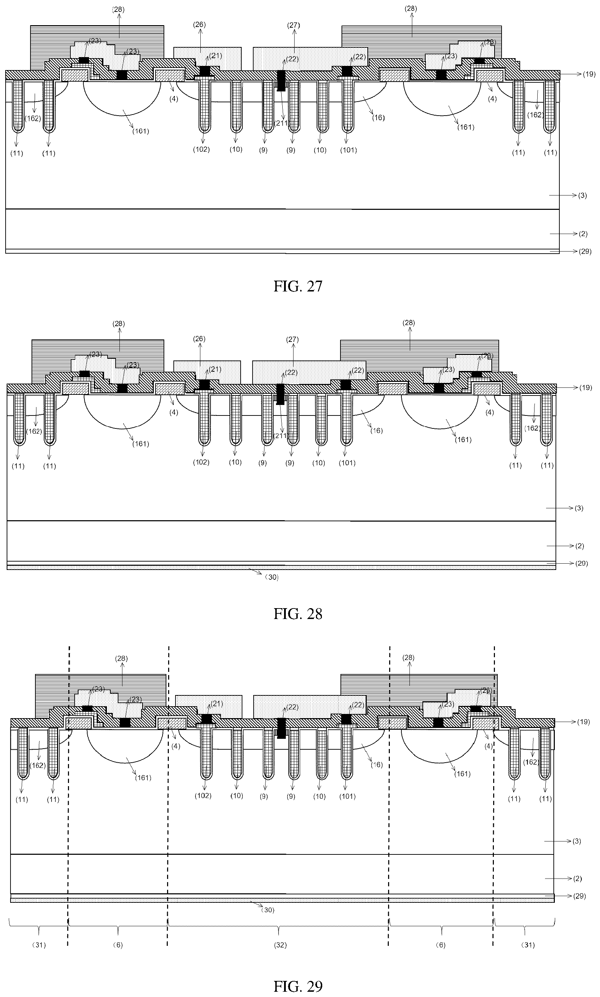

As shown in FIGS. 1 and 29, the present disclosure provides a preparation method of an insulated gate bipolar transistor (IGBT) device having a deep buffer layer and high-density trenches. A front-face high-density-trench MOSFET structure of the IGBT device of the present disclosure has the high-density trenches. Without increasing process costs, using different front-side processing technologies, such as implanting enhancement and carrier storage and other technologies, a capacitance composition ratio of the IGBT device of the present disclosure is easily adjusted to meet the needs of different application scenarios. Further, the present disclosure reduces a warpage degree of a wafer and enables a preparation of IGBT devices with a high density on the wafer having a larger size.

The preparation method comprises steps A-E. The step A comprises preparing epitaxial layers. The step B comprises preparing a front-face terminal structure. The step C comprises preparing a front-face high-density-trench MOSFET structure having the high-density trenches. The high-density trenches comprise cellular active trenches, cellular pseudo trenches, and scribe line trenches. The step D comprises preparing a circuit link layer and a passivation layer 28. The step E comprises preparing a back face of the IGBT device.

In one specific embodiment, the step A comprises steps S1-S2.

As shown in FIG. 2, the step S1 comprises growing a first epitaxial layer 2 on an upper surface of a semiconductor substrate 1 by vapor deposition; doping the first epitaxial layer with a first element.

In the embodiment, the first epitaxial layer is served as a buffer layer, and the semiconductor substrate 1 is specifically a silicon substrate 1. The first element is a trivalent element or a pentavalent element. When the first element is the trivalent element (such as boron), the first epitaxial layer is a P-type first epitaxial layer, and when the first element is the pentavalent element (such as arsenic or phosphorus), the first epitaxial layer 2 is an N-type first epitaxial layer. According to requirements of different application scenarios, a depth of the first epitaxial layer 2 and a concentration of the trivalent element or the pentavalent element doped in the first epitaxial layer 2 are adjustable.

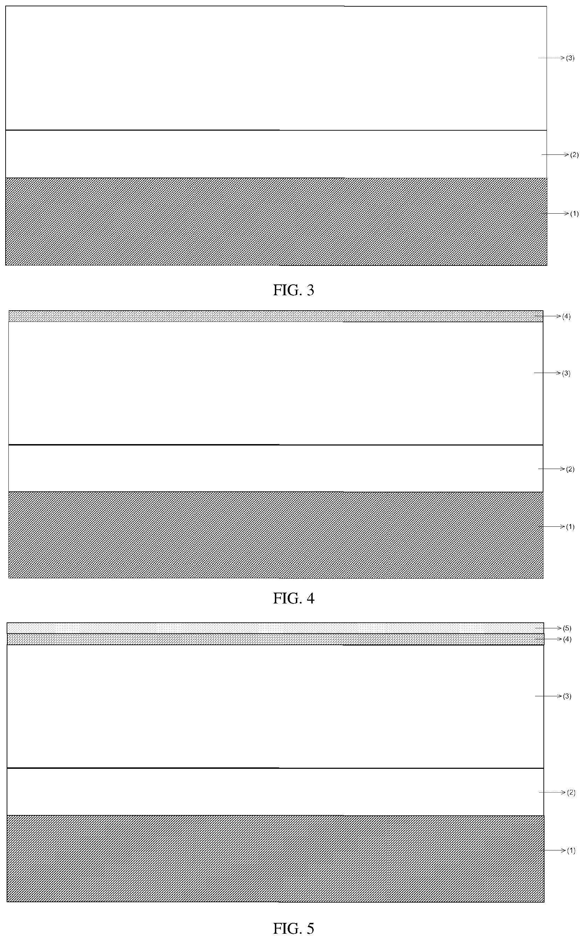

As shown in FIG. 3, the step S2 comprises growing a second epitaxial layer 3 on the first epitaxial layer 2 by the vapor deposition, and doping the second epitaxial layer 3 with a second element. The second epitaxial layer 3 is served as a voltage-resistant layer. The second element is the trivalent element or the pentavalent element. Depending on a polarity of the second epitaxial layer 3, the second epitaxial layer 3 may be a P-type second epitaxial layer 3 (doped with boron) or an N-type second epitaxial layer 3 (doped with arsenic or phosphorus).

The polarity of the second epitaxial layer 3 is the same as a polarity of the first epitaxial layer 2. According to the requirements of different application scenarios, a depth of the second epitaxial layer 3 and a concentration of the trivalent element or the pentavalent element doped in the second epitaxial layer 3 are adjustable.

In one specific embodiment, the step B comprises steps S3-S6.

As shown in FIG. 4, the step S3 comprises depositing silicon dioxide on the second epitaxial layer 3 to obtain a thick oxide layer 4 required by the front-face terminal structure.

As shown in FIG. 5, the step S4 comprises spin-coating a first photoresist layer 5 on the thick oxide layer 4 and defining a circuit pattern of a first mask on the first photoresist layer 5 through exposing the first mask under the photoetching machine.

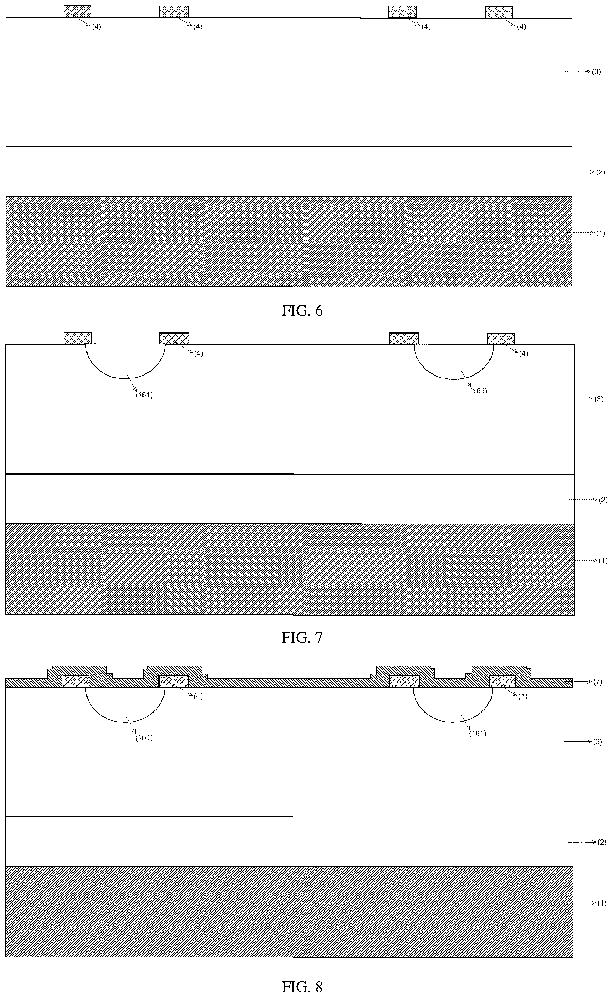

As shown in FIG. 6, the step S5 comprises transferring the circuit pattern to the thick oxide layer 4 by dry etching or wet etching and removing the first photoresist layer 5. Then, two groups of strip-shaped thick oxide layers 4 are obtained on two sides of the second epitaxial layer 3, and each groups of the strip-shaped thick oxide layers 4 comprises two strip-shaped thick oxide layers 4.

As shown in FIG. 7, the step S6 comprises performing ion implantation to implant first impurities on a portion, between the two groups of strip-shaped thick oxide layers 4, of the second epitaxial layer 3 to obtain terminal regions 6 (as shown in FIG. 29); and thermal activating the first impurities to obtain two terminal implantation regions 161. The first impurities comprise the trivalent element (to form an N-type MOSFET structure accordingly) or the pentavalent element (to form a P-type MOSFET structure accordingly). Specifically, the ion implantation is performed on the second epitaxial layer for one or more times to enable the terminal implantation regions 161 to have different withstand voltage values.

In one specific embodiment, the step C comprises steps S7-S18.

As shown in FIG. 8, the step S7 comprises preparing a hard film 7 on an upper surface of the second epitaxial layer 3. The hard film 7 is configured for etching of trenches and is made of silicon dioxide and is prepared by low-temperature chemical vapor deposition or a high-temperature furnace tube process.

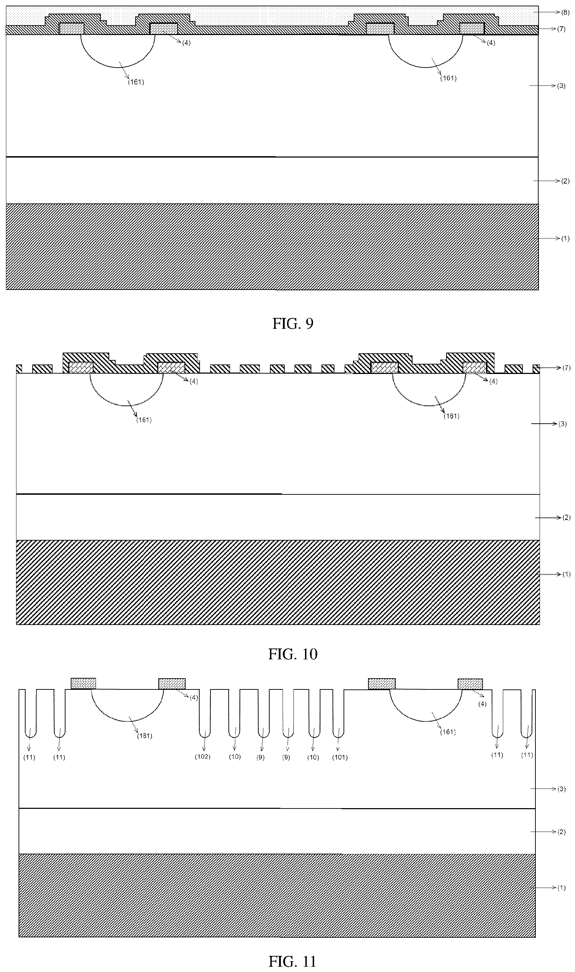

As shown in FIG. 9, the step S8 comprises spin-coating a second photoresist layer 8 on the hard film 7, and transferring high-density trench patterns on a second mask to the second photoresist layer 8 through exposing the second mask under the photoetching machine.

As shown in FIG. 10, the step S9 comprises after the high-density trench patterns are formed on the second photoresist layer 8, transferring the high-density trench patterns to the hard film 7 by the dry etching, and removing the second photoresist layer 8.

As shown in FIG. 11, the step S10 comprises after the high-density trench patterns are formed on the hard film 7, performing the dry etching on the second epitaxial layer 3 to form the high-density trenches, and removing the hard film 7.

In one specific embodiment, three kinds of high-density trenches are defined. The high-density trenches comprise two cellular active trenches 9, cellular pseudo trenches, and scribe line trenches 11. The cellular active trenches 9 and the cellular pseudo trenches are located in a middle of the second epitaxial layer. The scribe line trenches 11 are respectively located on two sides of the second epitaxial layer 3. The two cellular active trenches 9 are configured to realize a conduction effect of actual transistors.

The cellular pseudo trenches comprise two cellular floating pseudo trenches 10, a cellular source pseudo trench 101, and a cellular gate pseudo trench 102. The two cellular floating pseudo trenches 10 are disposed on two sides of the two cellular active trenches 9. The cellular source pseudo trench 101 is disposed on one side of a first cellular floating pseudo trench away from the cellular gate pseudo trench 102. The cellular gate pseudo trench 102 is disposed on one side of a second cellular floating pseudo trench away from the cellular source pseudo trench 101. By choosing to float, connecting to a gate 26 and an emitter 27, the effects of voltage resistance, capacitance adjustment, and a turn-on carrier distribution adjustment are improved. The scribe line trenches 11 are divided into two groups. Two groups of the scribe line trenches 11 are respectively located on the two sides of the second epitaxial layer 3. Each of the groups of the scribe line trenches 11 comprises two scribe line trenches 11, which reduce a risk of the warpage of the wafer having a large size.

As shown in FIG. 1, trenches (such as the scribe line trenches) defined in the scribe line implantation regions 31 is parallel or perpendicular to trenches defined on a main chip (i.e., the cellular active trenches 9 and the cellular pseudo trenches), and a density of the trenches defined in the scribe line implantation regions 31 is the same as a density of the trenches defined on the main chip, thereby forming the high-density trenches. The number of the trenches is not a limitation on the present disclosure, but is an exemplary implementation. The number of the trenches may be determined according to specific requirements, which is not limited thereto.

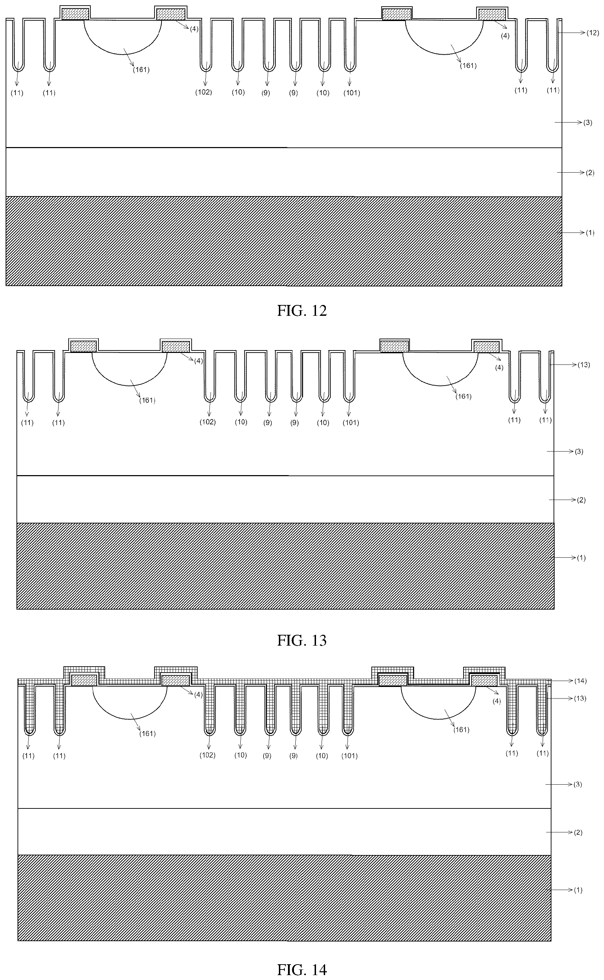

As shown in FIG. 12, the step S11 comprises growing a sacrificial oxide layer 12 on sidewalls of the high-density trenches through a furnace tube thermal oxidation process.

As shown in FIG. 13, the step S12 comprises removing the sacrificial oxide layer 12 by the wet etching and growing a gate oxide layer 13 by the high-temperature furnace tube thermal oxidation process.

As shown in FIG. 14, the step S13 comprises depositing a polysilicon layer 14 on the high-density trenches and the second epitaxial layer 3 through low-pressure chemical vapor deposition.

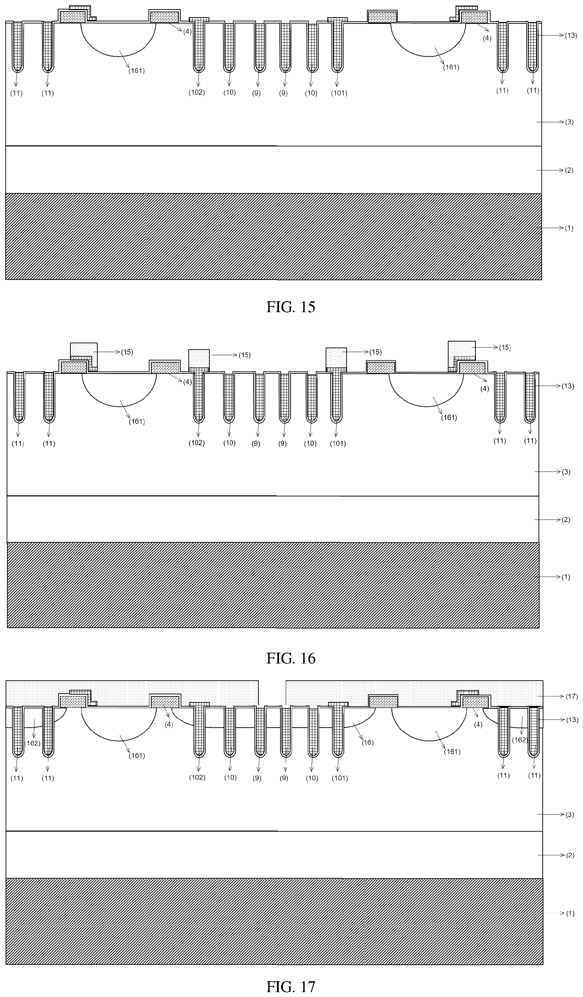

As shown in FIG. 15, the step S14 comprises spin-coating a third photoresist layer 15 on the polysilicon layer 14, defining a trench pattern of a third mask on the third photoresist layer 15 by exposing the third mask under the photoetching machine, and removing the third photoresist layer 15 after transferring the trench pattern onto the polysilicon layer 14 by the dry etching. In particular, the polysilicon layer 14 retained in the step S14 is configured to connect gate 26 to the cellular gate pseudo trench 102, and is served as a field plate structure for the terminal regions 6.

As shown in FIG. 16, the step S15 comprises performing the ion implantation to implant second impurities into the second epitaxial layer 3 to obtain a body region 6 and scribe line implantation regions 162; and thermally activating the second impurities. The body region 6 is disposed in the middle of the second epitaxial layer 3 and the scribe line implantation regions 162 are disposed on the two sides of the second epitaxial layer 3. The second impurities comprise the trivalent element (to form the N-type MOSFET structure accordingly) or the pentavalent element (to form the P-type MOSFET structure accordingly).

As shown in FIG. 17, the step S16 comprises spin-coating a fourth photoresist layer 17 on an upper surface of the polysilicon layer 14, defining an active region pattern of a fourth mask on the fourth photoresist layer through exposing the fourth mask under the photoetching machine, and removing the fourth photoresist layer 17.

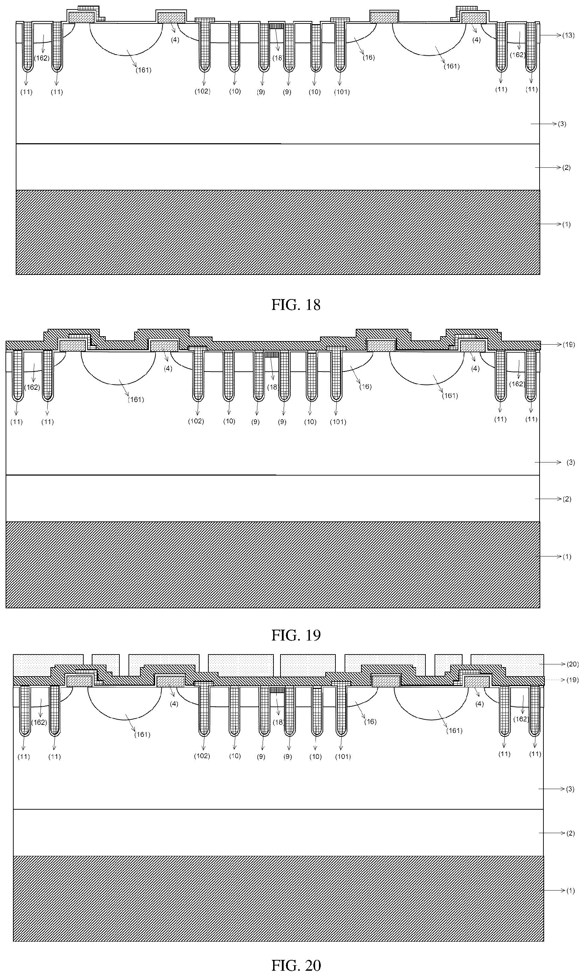

As shown in FIG. 18, the step S17 comprises performing the ion implantation to implant third impurities into the second epitaxial layer 3 to obtain the active region 18 and thermally activating the third impurities. The active region 18 is disposed between the two cellular active trenches 9. The third impurities comprise the trivalent element (to form the N-type MOSFET structure accordingly) or the pentavalent element (to form the P-type MOSFET structure accordingly).

As shown in FIG. 19, the step S18 comprises growing a silicon dioxide insulating layer 19 on the upper surface of the polysilicon layer 14.

In one specific embodiment, the step D comprises steps S19-S24.

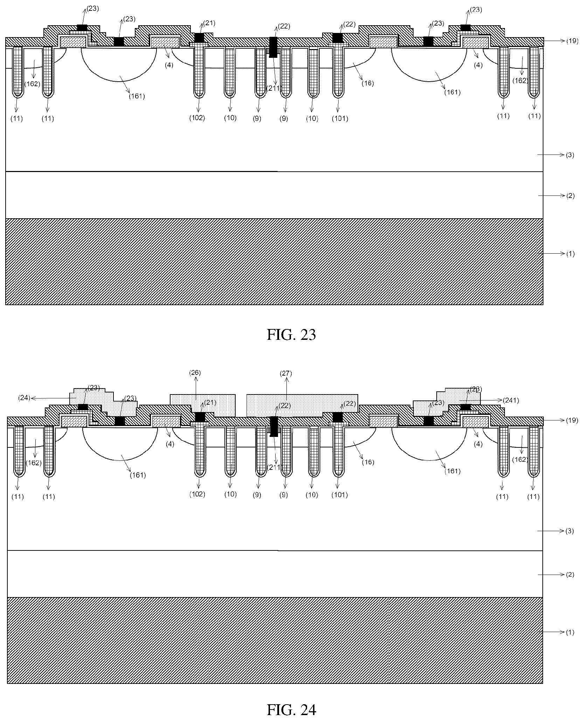

As shown in FIG. 20, the step S19 comprises spin-coating a fifth photoresist layer 20 on a surface of the silicon dioxide insulating layer 19 and defining contact hole patterns of a fifth mask on the fifth photoresist layer through exposing the fifth mask under the photoetching machine. The contact holes obtained in FIG. 23 comprise a gate contact hole 21, emitter contact holes 22, and terminal contact holes 23.

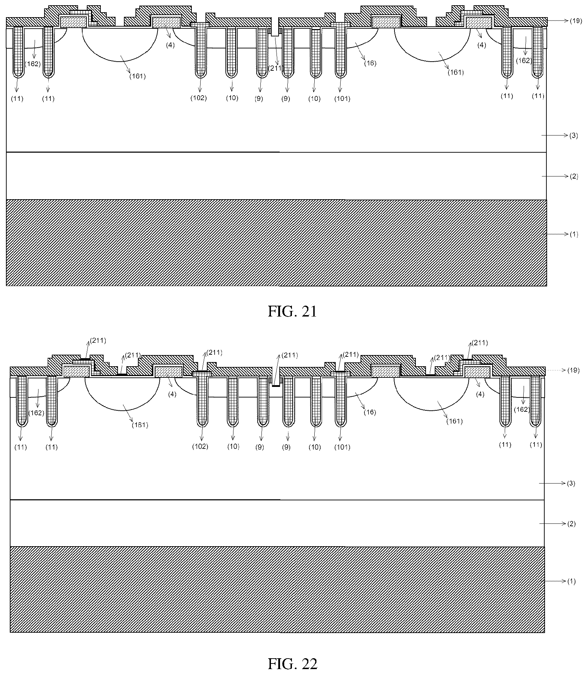

As shown in FIG. 21, the step S20 comprises after the contact hole patterns are transferred onto the fifth photoresist layer 20, transferring the contact hole patterns onto the silicon dioxide insulating layer 19 and performing the dry etching to form the gate contact hole, the emitter contact holes, and the terminal contact holes; and removing the fifth photoresist layer 20.

As shown in FIG. 22, the step S21 comprises doping fourth impurities into a bottom portion of the gate contact hole 21, bottom portions of the emitter contact holes 22, and bottom portions of the terminal contact holes 23 by performing the ion implantation, and annealing to activate the fourth impurities to form ohmic contact layers 211.

As shown in FIG. 23, the step S22 comprises depositing metal titanium as a bonding layer by the vapor deposition; forming a silicide by rapid thermal annealing; isotropically depositing metal tungsten; and removing metal tungsten outside the contact holes by dry the etching to form tungsten plugs. The tungsten plugs are disposed in the gate contact hole 21, the emitter contact holes 22, and the terminal contact holes 23.

As shown in FIG. 24, the step S23 comprises depositing an aluminum layer 24 by sputtering; spin-coating a sixth photoresist layer 25; transferring a gate pattern and emitter patterns on a sixth mask to the sixth photoresist layer through exposing the six mask under the photoetching machine; forming the circuit link layer by the dry etching or dry and wet mixing etching; and removing the sixth photoresist layer25. In particular, the step S23 defines a terminal metal field plate 241 and two electrodes, one of which is the gate 26 and the other is the emitter 27.

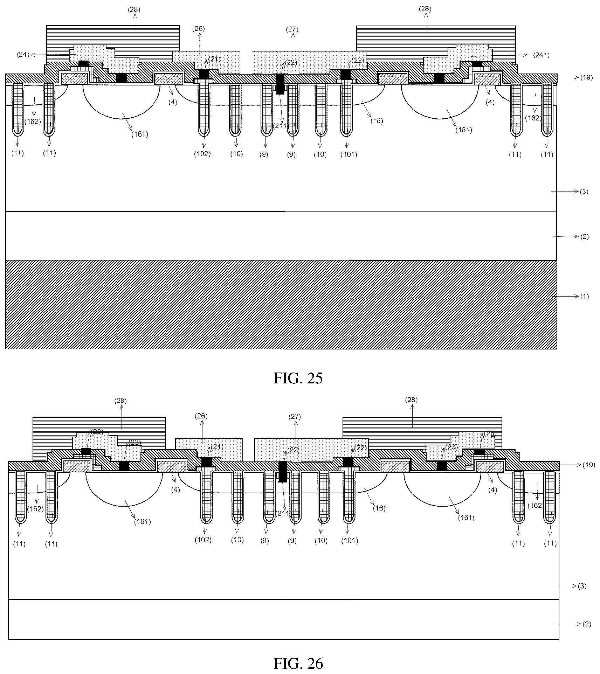

As shown in FIG. 25, the step S24 comprises depositing the passivation layer 28, and exposing bonding pads of the gate 26 and the emitter 27 through a photolithography process and an etching process.

In one specific embodiment, the step E comprises steps S25-S27.

As shown in FIG. 26, the step S25 comprises thinning the IGBT device from a back surface of the semiconductor substrate 1 until the first epitaxial layer 2 is exposed.

As shown in FIG. 27, the step S26 comprises implanting a third element into a back surface of the first epitaxial layer 2 by performing the ion implantation, and activating the third element to form a collector 29 and the reverse conductive channels 291. The third element is the trivalent element (to form the N-type IGBT device) or the pentavalent element (to form the P-type IGBT device). An energy range of the third element is 10 -40k, a dose range of the third element is 1e12-1e13/cm2. The reason why the reverse conductive channels 291 are formed is that a concentration of the third element in the reverse conductive regions 201 is greater than a concentration of the third element in the collector 29. After the third element is activated, a polarity of the reverse conductive channels 291 is opposite to a polarity of the collector 29.

As shown in FIG. 28, the step S27 comprises performing alloy on a back surface of the collector by evaporation or sputtering, and annealing to realize ohmic contact and form a back metal layer 30.

As shown in FIGS. 1 and 29, the embodiment of the present disclosure further provides an IGBT device having a deep buffer layer and high-density trenches. The IGBT device comprises terminal regions 6, scribe line implantation regions 31, and a main region 32. The scribe line implantation regions 31 and the main region 32 comprise the high-density trenches. The high-density trenches comprise cellular active trenches, cellular pseudo trenches, and scribe line trenches. The ion implantation is repeatedly performed on the terminal region 6 for different times according to different voltage level requirements thereof. The ion implantation is repeatedly performed for different times on the scribe line implantation regions 31 according to different width requirements thereof. The ion implantation is repeatedly performed for different times on the main region 32 according to different current specifications thereof.

An area of a 12-inch wafer is 2.25 times that of an 8-inch wafer and 4 times that of a 6-inch wafer. Therefore, under the same production efficiency, a larger-sized wafer at least double a chip output rate. The preparation method of the present disclosure to solve the warpage problem when producing IGBT devices on a large-size wafer. At the same time, the depth of the buffer layer and the concentration of the first element in the buffer layer are easy to adjust. The present disclosure fully meets requirements for trench density, trench type, and buffer layer in different application scenarios, and improves a yield rate of IGBT devices (such as chips).

## Claims

1. A preparation method of an insulated gate bipolar transistor (IGBT) device, comprising:
a step A: preparing epitaxial layers;
a step B: preparing a front-face terminal structure;
a step C: preparing a front-face high-density-trench metal oxide semiconductor field effect transistor (MOSFET) structure having high-density trenches;
a step D: preparing a circuit link layer and a passivation layer (28); and
a step E: preparing a back face of the IGBT device;
wherein the high-density trenches comprise cellular active trenches (9), cellular pseudo trenches, and scribe line trenches (11).

2. The preparation method of claim 1, wherein the step A comprises:
a step S1: growing a first epitaxial layer (2)on an upper surface of a semiconductor substrate by vapor deposition; doping the first epitaxial layer (2)with a first element; and
a step S2: growing a second epitaxial layer (3) on the first epitaxial layer (2)by the vapor deposition; doping the second epitaxial layer (3) with a second element;
wherein the first element is a trivalent element or a pentavalent element, the second element is the trivalent element or the pentavalent element.

3. The preparation method of claim 2, wherein the first epitaxial layer (2)is a buffer layer; the second epitaxial layer (3) is a voltage-resistant layer; a polarity of the second element doped in the second epitaxial layer (3) is the same as a polarity of the first element doped in the first epitaxial layer; the trivalent element comprises boron and the pentavalent element comprises arsenic or phosphorus.

4. The preparation method of claim 1, wherein the step B comprises:
a step S3: depositing silicon dioxide on the second epitaxial layer (3) to obtain a thick oxide layer (4);
a step S4: spin-coating a first photoresist layer (5) on the thick oxide layer (4); defining a circuit pattern of a first mask on the first photoresist layer (5) through exposing the first mask under the photoetching machine;
a step S5: transferring the circuit pattern to the thick oxide layer (4) by dry etching or wet etching, and removing the first photoresist layer (5); and
a step S6: performing at least one ion implantation to implant first impurities on the second epitaxial layer (3) to obtain terminal regions (6); thermal activating the first impurities to obtain terminal implantation regions (161);
wherein the first impurities comprise a trivalent element or a pentavalent element.

5. The preparation method of claim 4, wherein the step C comprises:
a step S7: preparing a hard film (7) on an upper surface of the second epitaxial layer (3); wherein the hard film (7) is made of silicon dioxide and is prepared by low-temperature chemical vapor deposition or a high-temperature furnace tube process;
a step S8: spin-coating a second photoresist layer (8) on the hard film (7); defining high-density trench patterns of a second mask on the second photoresist layer (8) through exposing the second mask under the photoetching machine;
a step S9: after the high-density trench patterns are formed on the second photoresist layer (8), transferring the high-density trench patterns to the hard film (7) by the dry etching; removing the second photoresist layer (8);
a step S10: after the high-density trench patterns are formed on the hard film (7), performing the dry etching on the second epitaxial layer (3) to form the high-density trenches; removing the hard film (7);
a step S11: growing a sacrificial oxide layer (12) on sidewalls of the high-density trenches through a furnace tube thermal oxidation process;
a step S12: removing the sacrificial oxide layer (12) by the wet etching and growing a gate oxide layer (13) by the high-temperature furnace tube thermal oxidation process;
a step S13: depositing a polysilicon layer (14) on the high-density trenches and the second epitaxial layer (3) through low-pressure chemical vapor deposition;
a step S14: spin-coating a third photoresist layer (15) on the polysilicon layer (14); defining a trench pattern of a third mask on the third photoresist layer (15) by exposing the third mask under the photoetching machine; removing the third photoresist layer (15) after transferring the trench pattern onto the polysilicon layer (14) by the dry etching;
a step S15: performing the ion implantation to implant second impurities into the second epitaxial layer (3) to obtain a body region (16) and scribe line implantation regions (31), and thermally activating the second impurities; wherein the second impurities comprise the trivalent element or the pentavalent element;
a step S16: spin-coating a fourth photoresist layer (17) on an upper surface of the polysilicon layer (14); defining an active region pattern of a fourth mask on the fourth photoresist layer (17) through exposing the fourth mask under the photoetching machine; and removing the fourth photoresist layer (17);
a step S17: performing the ion implantation to implant third impurities into the second epitaxial layer (3) to obtain an active region (18) and thermally activating the third impurities; wherein the third impurities comprise the trivalent element or the pentavalent element; and
a step S18: growing a silicon dioxide insulating layer (19) on the upper surface of the polysilicon layer (14).

6. The preparation method of claim 5, wherein the cellular active trenches (9) and the cellular pseudo trenches are located in a middle of the second epitaxial layer (3); the scribe line trenches (11) are respectively located in two sides of the second epitaxial layer (3); the cellular pseudo trenches comprise cellular floating pseudo trenches (10), a cellular source pseudo trench (101), and a cellular gate pseudo trench (102).

7. The preparation method of claim 5, wherein the step D comprises:
a step S19: spin-coating a fifth photoresist layer (20) on a surface of the silicon dioxide insulating layer (19) and defining contact hole patterns of a fifth mask on the fifth photoresist layer (20) through exposing the fifth mask under the photoetching machine; wherein the contact hole patterns comprise a gate contact hole pattern, emitter contact hole patterns, and terminal contact hole patterns;
a step S20: after the contact hole patterns are transferred onto the fifth photoresist layer (20), transferring the contact hole patterns onto the silicon dioxide insulating layer and performing the dry etching to form the gate contact hole (21), the emitter contact holes (22), and the terminal contact holes (23); removing the fifth photoresist layer (20);
a step S21: doping fourth impurities into a bottom portion of the gate contact hole, bottom portions of the emitter contact holes (22), and bottom portions of the terminal contact holes (23) by performing the ion implantation; and annealing to activate the fourth impurities to form ohmic contact layers (211);
a step S22: depositing metal titanium as a bonding layer by the vapor deposition; forming a silicide by rapid thermal annealing, isotropically depositing metal tungsten; and removing metal tungsten outside the contact holes by dry the etching to form tungsten plugs;
a step S23: depositing an aluminum layer (24) by sputtering; spin-coating a sixth photoresist layer (25); transferring a gate pattern and emitter patterns of a sixth mask onto the sixth photoresist layer (25) through exposing the six mask under the photoetching machine; forming the circuit link layer by the dry etching or dry and wet mixing etching; and removing the sixth photoresist layer (25); and
a step S24: depositing the passivation layer (28), and exposing bonding pads of the gate and the emitter through a photolithography process and an etching process.

8. The preparation method of claim 1, wherein the step E comprises:
a step S25: thinning the IGBT device from a back surface of the semiconductor substrate until the first epitaxial layer (2)is exposed;
a step S26: implanting a third element into a back surface of the first epitaxial layer (2)by performing the ion implantation; activating the third element to form a collector and the reverse conductive channels; wherein the third element is the trivalent element or the pentavalent element; an energy range of the third element is 10 -40k, a dose range of the third element is 1e12-1e13/cm²; after the third element is activated, a polarity of the reverse conductive channels is opposite to a polarity of the collector (29); and
a step S27: performing alloy on a back surface of the collector (29) by evaporation or sputtering, and annealing to realize ohmic contact and form a back metal layer (30).

9. An IGBT device having a deep buffer layer and high-density trenches, wherein the IGBT device is prepared by the preparation method of any one of claims 1-8.

10. The IGBT device of claim 9, wherein the IGBT device comprises terminal regions (6), scribe line implantation regions (31), and a main region (32); the high-density trenches are defined in the scribe line implantation regions (31) and the main region; the high-density trenches comprise the cellular active trenches (9), the cellular pseudo trenches, and the scribe line trenches (11).
